# EUROPEAN PATENT APPLICATION

(11) **EP 4 675 682 A1**
(43) Date of publication of application: **07.01.2026**
(21) Application number: 25185611.8
(22) Date of filing: 26.06.2025
(51) Int. Cl.: H01L 23/495, H01L 23/48, H01L 23/31, H01L 21/48, H01L 21/56

(54) **SEMICONDUCTOR PACKAGE HAVING LEAD FRAME WITH LEADS OF DIFFERENT SIZES AND METHOD OF MANUFACTURE**

(30) Priority: 02.07.2024 IN 202441050533
(71) Applicant: NXP B.V., 5656 AG Eindhoven (NL)
(72) Inventor: Halba, Rohit, 5656AG Eindhoven (NL); Gupta, Pawan Kumar, 5656AG Eindhoven (NL); Tiwari, Swapnil, 5656AG Eindhoven (NL); Liu, Huanhuan, 5656AG Eindhoven (NL)
(74) Representative: Miles, John Richard

(57) **Abstract**

A semiconductor package comprises a leadframe with a first lead and a second lead where the first lead has a larger size compared to the second lead. The lead frame further comprises a die attach area on which a die with one or more bond pads of the die is attached and where the first lead and the second lead extend outwardly from the die attach area. The one or more bond pads are associated with the first lead and a plurality of bond wires is arranged between a bond pad and the first lead.

## Description

### TECHNICAL FIELD

Embodiments of the subject matter described herein relate generally to a semiconductor package such as a quad flat package (QFP) having a lead frame with leads of different sizes and method of manufacture.

### BACKGROUND

A semiconductor package such as a quad flat package (QFP) finds application in a wide variety of electronic components and systems. The semiconductor package protects a die, also known as an integrated circuit, and eases handling of the die. The semiconductor package includes a lead frame having a die attach area and leads. A die is positioned in the die attach area and bond wires electrically couple the die to respective leads of the lead frame. The die, the bond wires, and a portion of each lead are encapsulated in an encapsulant while a remainder of each lead not encapsulated defines a pin for mounting the semiconductor package on a printed circuit board (PCB).

### BRIEF DESCRIPTION OF THE DRAWINGS

A complete understanding of the subject matter may be derived by referring to the detailed description and claims when considered in conjunction with the following figures, wherein like reference numbers refer to similar elements throughout the figures.
FIG. 1 shows an example top view of a lead frame of a semiconductor package in accordance with an embodiment.
FIG. 2 is shows another example top view of a lead frame in accordance with an embodiment.
FIG. 3 is shows yet another example top view of a lead frame in accordance with an embodiment.
FIG. 4 is shows another example top view of a lead frame in accordance with an embodiment.
FIGs. 5A-5D illustrate a set of steps associated with a method of manufacture of a semiconductor package having a lead frame with different size leads in accordance with an embodiment.
FIG. 6 illustrates a comparison of insertion loss and signal quality of a conventional lead and a reduced width lead of a lead frame in accordance with an embodiment.

### DETAILED DESCRIPTION

The detailed description of the appended drawings is intended as a description of the currently preferred embodiments of the present disclosure, and is not intended to represent the only form in which the present disclosure may be practiced. It is to be understood that the same or equivalent functions may be accomplished by different embodiments that are intended to be encompassed within the spirit and scope of the present disclosure.

The leads of a lead frame in an semiconductor package such as a quad flat package (QFP) conventionally have a same size which makes meeting voltage (IR) drop, dynamic ripple, electromagnetic, and thermal requirements of the die difficult. Increasing number of power leads of the lead frame is a costly solution for meeting the requirements because less signal leads are then available on the semiconductor package for connecting to a die mounted on a die attach area of the lead frame.

Embodiments disclosed herein are directed to a lead frame of a semiconductor package having leads of different sizes. The leads include power leads and signal leads. In an example, the power leads are thicker, wider, or both thicker and wider than the signal leads to meet IR drop, dynamic ripple, electromagnetic, and thermal requirements of a die attached in a die attach area of the lead frame while the signal leads have at least a minimum thickness or minimum width per manufacturer design rules. Further, plurality of bond wires is arranged between one or more bond pads of the die and a lead to form an electrical connection between the bond pads and the die. Well known structures and techniques have not been shown in detail in order not to obfuscate the description.

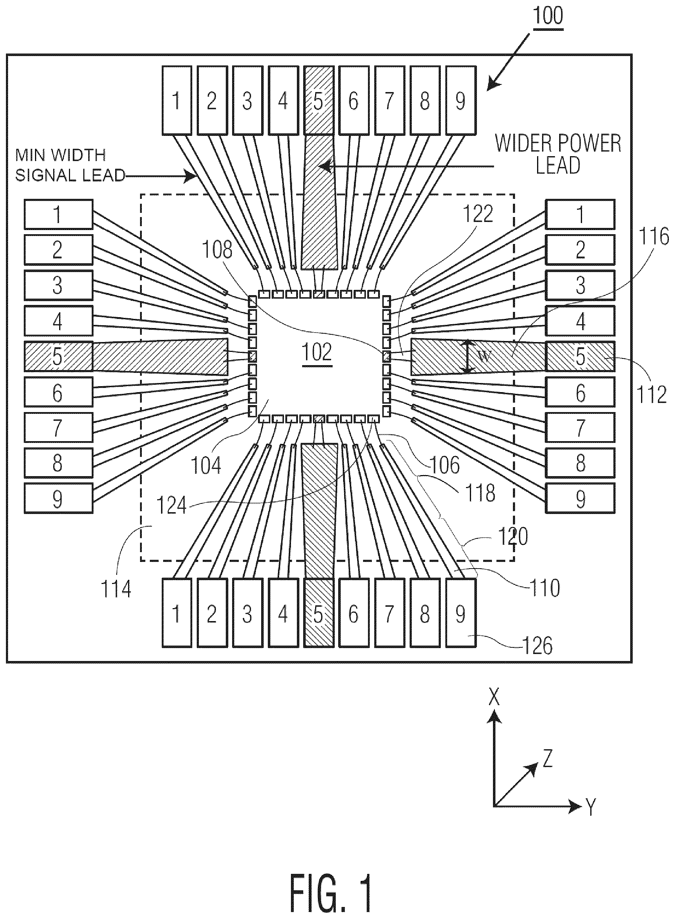

FIG. 1 shows an example top view of a lead frame 100 of a semiconductor package in accordance with an embodiment. The lead frame 100 is a central supporting structure of such a package. The lead frame 100 includes a die attach area 104 to which a die 102 such as an integrated circuit is attached and leads which surround the die attach area 104 and extend outwardly from the die attach area 104. In an example, the die attach area 104 may define a surface for attaching the die 102. The die 102 further has bond pads which allow for electrically coupling bond wires to respective leads of the lead frames. Examples of the bond wires are shown as bond wires 106, 122, an example the bond pads is shown as bond pad 108, and examples of leads are shown as leads 110, 116. The bond wires and bond pads may be fabricated from aluminum, copper, gold, silver, or a functional equivalent. The die pad, bond wires, bond pads, and a portion of the leads are encapsulated in an encapsulant 114 such as an epoxy shown as a dotted line to form the semiconductor package which protects the die 102 and eases handling of the die 102. In an example, the semiconductor package may be a quad flat package (QFP). Further, a remainder of the lead which is not encapsulated defines pins, examples of which are shown as pin 112, 126, to facilitate mounting of the semiconductor package on a printed circuit board (PCB) in an example.

The semiconductor die may be made from any semiconductor material or combinations of materials, such as gallium arsenide, silicon germanium, silicon-on-insulator (SOI), silicon, monocrystalline silicon, the like, and combinations of the above. Further, the lead frame 100 is preferably fabricated from a conductive metal material (e.g., copper, aluminum) through a standard etching or stamp punch process. In an example, the die attach area 104 has four linear sides and each side thereof has a subset of the plurality of leads extending outwardly or away from the die attach area 104 in a same plane. The surface of the die attach area 104 may include generally planar top and bottom surfaces, on which the die 102 may be physically attached such as by an adhesive. Each lead of the lead frame may be defined by an inner portion and an outer portion along a longitudinal direction of the lead. As illustrated for lead 110 as an example, the inner portion 118 may generally be closest to the die pad 104 and land on the bond pad and the outer lead frame portion 120 may generally terminate at a pin 126 such as a J pin or gull wing pin to be eventually soldered or otherwise affixed to the PCB after the semiconductor package is formed. Similarly, lead 116 may have a corresponding inner portion and outer portion and terminate at a pin 122 which is not shown. In an example, the lead and pin may be formed as a unitary structure even though portions of the lead may be referred to herein as separate components.

The plurality of leads may be either signal leads or power leads. The signal leads, an example of which is shown as signal lead 110, may carry input/output signals (e.g., which may be susceptible to noise) to and from the die 102 associated with operation of the die 102 while the power lead, an example of which is shown as power lead 116, may carry power to the die 102 such as 1.2 volts power connection from a power domain. Further, to distinguish the signal leads from the power leads in the various figures, the signal leads are illustrated without cross hatching while the power leads are illustrated with cross hatching. In an example, the signal of the signal lead may have an amplitude which varies in time while the power of the power lead may have a fixed voltage over time to provide the power to the die 102. The lead frame 100 may have a plurality of signal leads and a plurality of power leads. A plurality of power leads could be used to meet IR, dynamic ripple, electromagnetic, and thermal requirements of the die 102 by providing the power to the die 102 via the plurality of power leads, but which results in fewer signal leads being available to carry signals to the die 102.

Embodiments disclosed herein are directed to the lead frame 100 having leads with different sizes. The plurality of leads may include the power lead which carry power and the signal lead which carry signals, where the power lead which is shaded has a larger size compared to the signal lead which is not shaded. In an example, the power lead has one or more of a larger width (W as shown) and thickness compared to the signal lead. A width W of the power lead may be a direction transverse or perpendicular to a longitudinal direction of the power lead. Thickness may be increased in a Z direction while width may be increased in an X or Y direction transverse to the longitudinal direction of a lead, where the Z direction is perpendicular to the X and Y direction. As shown and as an example, the width W of the power lead is greater in the X direction compared to a width in the same X direction of a signal lead along a same side of the die attach area 104. Further, to maintain a same size of the lead frame 100 the signal lead may have a width equal to a minimum width per a manufacturer design rules in an example to increase available space for the larger sized power lead along a side of the die attach area 104 or a thickness equal to a minimum thickness per manufacturer design rules. The manufacturer design rule may define a size of the leads which can be formed based on a process to form the lead. The minimum thickness may vary depending on whether the manufacture is by an etching process or a stamp punch from a metal plate or strip as examples. In an example, the inner portion of the signal lead may have a smaller width but the pin of the signal lead may have a same size as the pin of the power lead. Further, two or more bond wires, examples of which are bond wires 122, may be coupled from a bond pad to the inner portion of the power lead 116 and the outer portion of the power lead 116 may terminate at the pin 112. The power lead may have a large width to allow a plurality of bond wires to land on the power lead. The large width or thickness of the power lead also adds more surface area and reduces resistance and impedance from a bond pad to the power lead to meet voltage (IR) drop, dynamic ripple, electromagnetic, and thermal requirements of the die 102.

In an example, a width of a signal lead may be decreased and additional space provided by the smaller signal lead may be used to increase a width of the power lead while maintaining a same size of a conventional lead frame. If a lead frame conventionally has 8 signal leads and 1 power lead with width X (where X is a certain dimension) along a side of the die attach area, the signal lead may be each reduced to size X/2 gaining an extra space of 4X which may be used to increase the size of the power lead between 3X and 4X in the example. Other variations on the size of the power lead are also possible including 1.2X, 3X, and 5X as examples.

Further, characteristics of the power lead, signal lead, bond pad, or bond wire may be described here for one instance of the component. It is understood that the characteristics of the one component may apply to other of the same component shown as a same structure as well to simply description of the various embodiments. For example, reference to a width of one power lead of the lead frame may apply to the width of the other power leads in the same lead frame. As another example, a respective connection of a bond wire from a bond pad to one power lead may also exist for another power lead. Still additionally, reference to a width of one signal lead of the lead frame may apply to the width of the other power signal leads in the same lead frame.

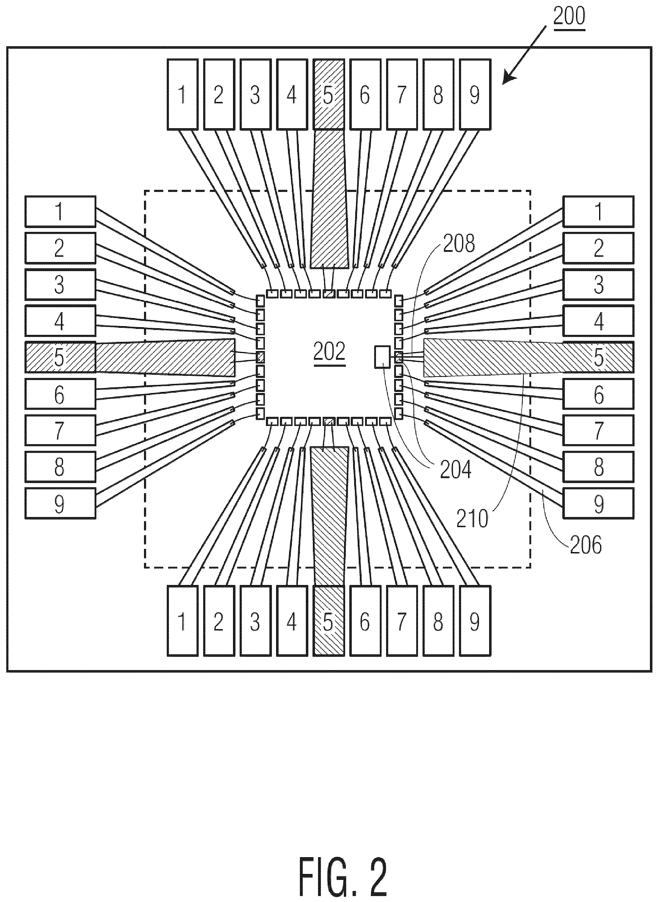

FIG. 2 shows another example top view of a lead frame 200 in accordance with an embodiment. The plurality of leads may include the power lead, an example of which is power lead 210 to carry power to the die 202 and the signal lead, an example of which is signal lead 206 which carry signals to the die 202, where the power lead 210 has a larger size compared to the signal lead 206. The size may be one or more of a larger width (as shown) and thickness of the power lead compared to the signal lead. Further, to maintain a same size of the lead frame 200, the smaller width of the signal lead may meet minimum width per manufacturer design rules in an example to increase available space for the larger width power lead. A plurality of bond pads may be used to electrically couple the bond wires to the power lead. In an example, the power lead 210 may have a plurality of bond pads 204 to facilitate landing more than one bond wire 208 to the power lead 210, illustrated in this example as three bond wires 208 and two bond pads 204. The increased number of bond wires from two or more bond pad to the power lead reduces an inductance and resistance from the pin to the die 202 to meet IR drop, dynamic ripple, electromagnetic, and thermal requirements for the die 202.

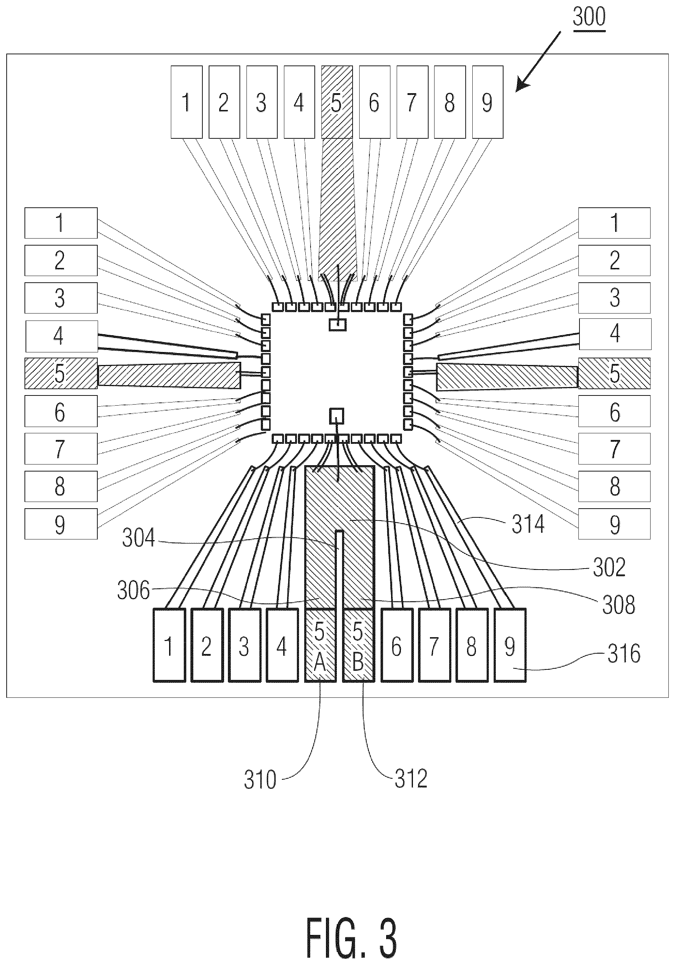

FIG. 3 is shows yet another example top view of a lead frame 300 in accordance with an embodiment. The plurality of leads may include power leads which carry power and signal leads which carry signals, examples of which are shown as signal lead 314 and power lead 302, where the power lead 302 is a larger size compared to the signal lead 314. The size may be one or more of a larger width and thickness of the power lead compared to one or more of the width and thickness of the signal lead to allow connection of multiple bond wires from multiple bond pads in an example. Further, to maintain a same size of the lead frame 300, an inner portion and outer portion of the signal lead may have a width equal to a minimum width per manufacturer design rules in an example to increase available space for the larger sized power lead. In an example, the power lead 302 may have a slot 304 which extends from the outer lead frame portion of the power lead 302 toward an inner portion of the power lead 302. Each side 306, 308 of the outer lead frame portion of the power lead 302 may terminate with a respective pin 310, 312 which may be collectively wider in surface area than a pin 316 of the signal lead 314 in the example. In an example, the multiple pins 310, 312 of the power lead 302 also allows for coupling a respective loop capacitor between the pin and PCB to increase capacitance and decrease an inductance of the power lead 302 to meet IR, dynamic ripple, electromagnetic, and thermal requirements of the die compared to the signal lead 314. Further, formation of the slot in the power lead facilitates fabrication of the power lead using a conventional molding process and reduces amount of thermal expansion for each pin of the power lead and degradation of solder between the pins and the PCB on which the semiconductor package is mounted.

In an example, a width of a pin of a signal lead may decreased and additional space provided by the smaller pin of a signal lead may be used to increase a width of the pin of the power lead while maintaining a same size of a conventional lead frame along a side of the die pad. If a lead frame conventionally has 8 signal leads and 1 power leads with pin width of X along a side of the die attach area, the pins of the signal leads may be each reduced to size 7/8 (X) gaining an extra space of X which may be used to increase the size of the pin of the power lead between 1X and 2X larger than the pins of the signal lead in an example.

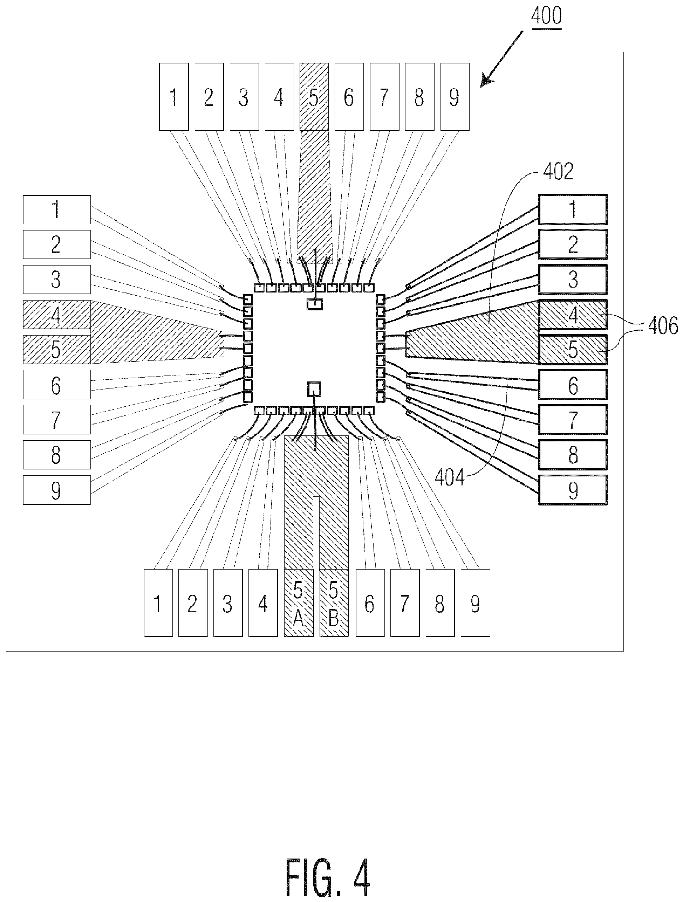

FIG. 4 is shows another example top view of a lead frame 400 in accordance with an embodiment. The plurality of lead frames may include a power lead, an example of which is power lead 402, which carry power and a signal lead, an example of which is signal lead 404, which carry signals, where the power lead has a larger size compared to the signal lead. The size may be one or more of a larger width (as shown) and thickness of the power lead compared to a respective width or thickness of the signal lead. In an example, the power lead such as the power lead 402 may be formed by merging two power leads together to form the power lead and to increase width of the power lead. Further, the power lead may terminate with two pins while occupying a similar space to the two signal leads. In this example, the lead frame 100 may have 6 signal leads and 1 power lead along a side of the die attach area rather than 7 signal lead and 1 power lead shown by earlier examples. Further, a width of a signal lead may be greater than a minimum width per manufacturer design rules so that cross talk between the signal leads which could occur with a smaller width signal lead is lessened. The larger width or thickness of the power lead reduces resistance and impedance from a bond pad to the power lead to meet voltage drop (IR drop), dynamic ripple, electromagnetic, and thermal requirements of the die and the signal lead with a width greater than the minimum width per manufacturer design rules reduces cross-talk between adjacent signal leads.

In some examples, two or more power leads may not be adjacent to each other on the lead frame 400 to merge to form the power lead larger than the signal lead. In this situation, a signal lead adjacent to a power lead may be reconfigured as a power lead adjacent with another power lead and the power lead not adjacent to the other power lead may be reconfigured as a signal lead so that two power leads are adjacent to each other and capable of being merged to form the larger power lead. Further, the different types of power leads which are illustrated in separate lead frames may be combined onto a single lead frame and the single lead frame may not have only one type of power lead as described herein.

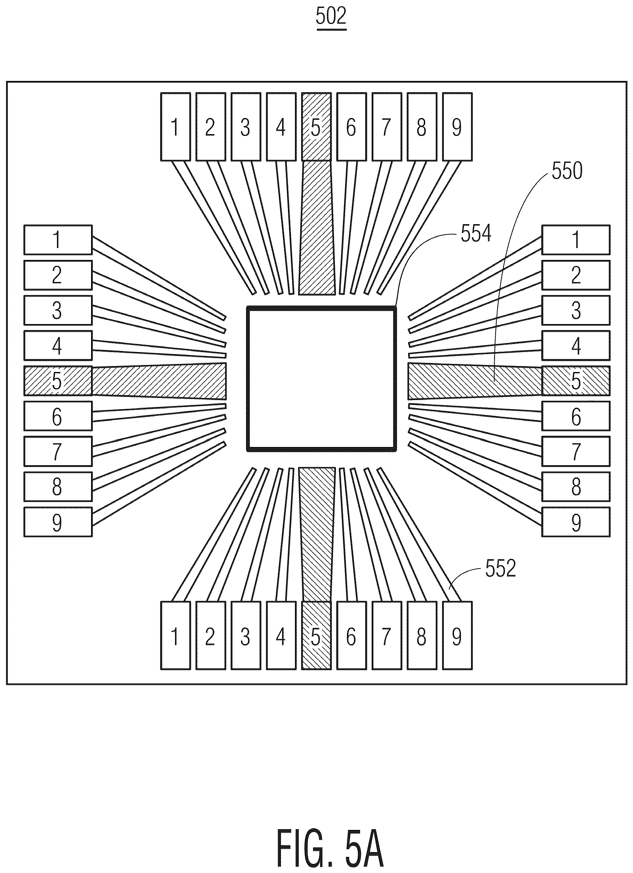

FIGs. 5A-5D illustrate a set of steps associated with a method of manufacture of a semiconductor package having a lead frame with different size leads in accordance with an embodiment. Steps 502-508 are illustrative in nature and the manufacturing process may include more or less steps and in some examples steps may be combined.

As shown in FIG. 5A which illustrates step 502 of a manufacturing process, a lead frame having a power lead and signal lead is formed, where the power lead, an example of which is power lead 550, has one or more of a width and thickness larger than a width or thickness of the signal lead, an example of which is signal lead 552. The width of power lead 550 is wider than the signal lead 552 in this example. A die attach area 554 may serve as a mount point for a die and made of a conductive material such as copper. The formation of the lead frame may be based on a stamp punch of a metal plate or strip or etching process in an example. In some examples, the power lead may have a slot spanning from an inner portion of the power lead to the outer portion and terminate at two or more pins. In some examples, the signal lead may have a width or thickness no less than a minimum width or thickness per manufacturer design rules to not affect a signal quality and cause significant attenuation at a desired frequency.

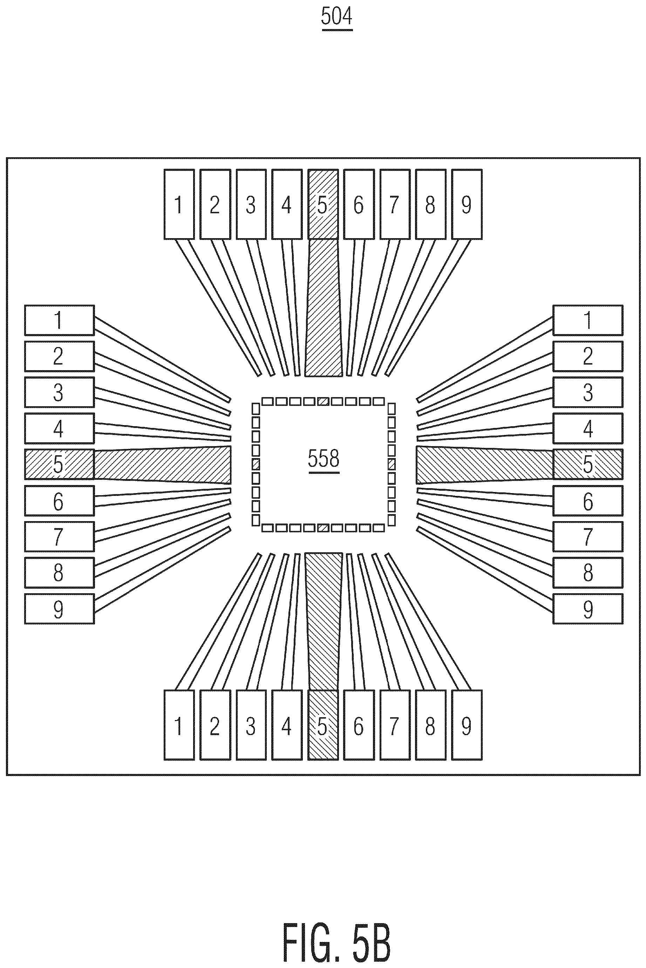

As shown in FIG. 5B which illustrates step 504 of the manufacturing process, a die 558 is mounted on the die attach area of the lead frame. The die 558 may be mounted with an adhesive in an example. The die 558 may have a plurality of bond pads to facilitate electrically coupling the die 558 to the power and signal leads. In an example, the shaded bond pads may be used to facilitate the coupling to the power leads. The bond pads may be formed on the die using welding, soldering, deposition, plating or other like techniques or by filling vias or through holes to form an exposed end.

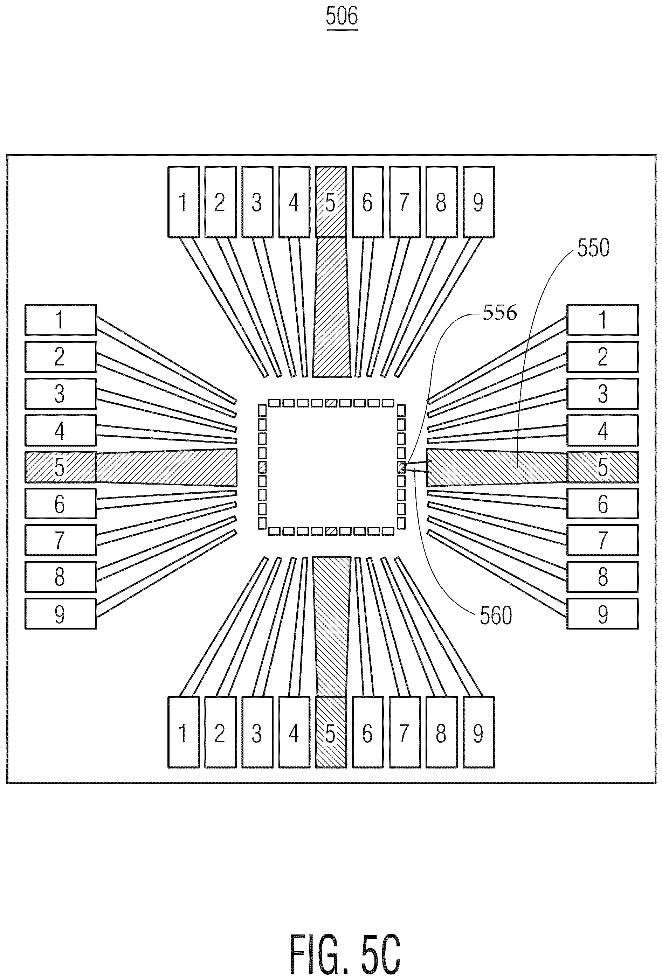

As shown in FIG. 5C which illustrates step 506 of the manufacturing process, a plurality of bond wires, an example of which is bond wire 560, may be electrically coupled from one or more bond pads, an example of which is bond pad 556, to the power lead, an example of which is power lead 550. The bond wires may carry signals or power between a printed circuit board (PCB) on which a semiconductor package is mounted and bond pads and the larger size power lead allows for more landing points for the bond wires on the power lead. The bond wires are preferably used to electrically couple the leads to respective ones of the bond pads of the semiconductor die using a conventional wire bonding process.

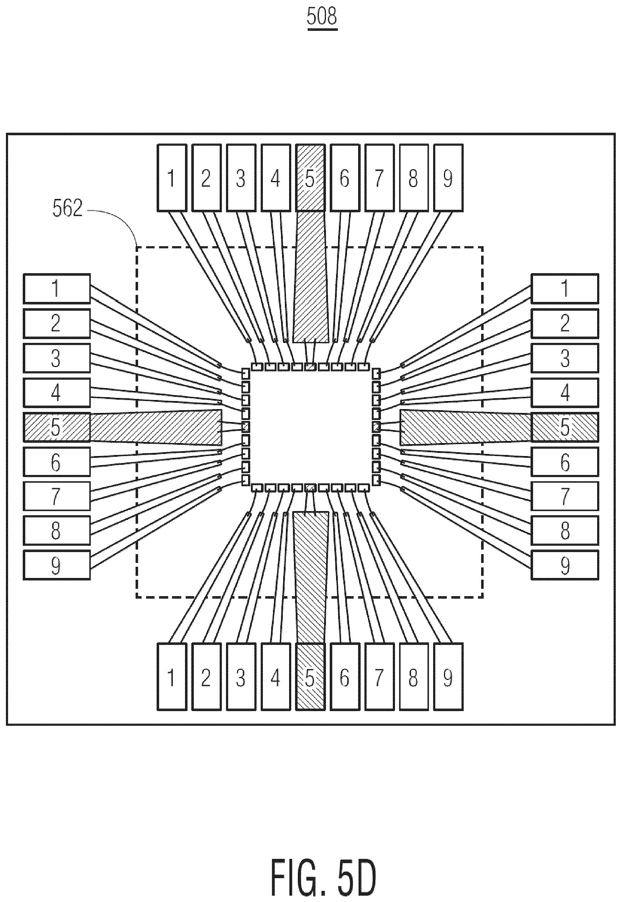

As shown in FIG. 5D which illustrates step 508, the lead frame and leads, bond wires, and bond pads are encapsulated in an encapsulant 562 such as an epoxy molding compound (EMC) to form the semiconductor package. The encapsulant 562 serves to protect the die and facilitate ease of handling the die while leaving pins of the lead frame exposed.

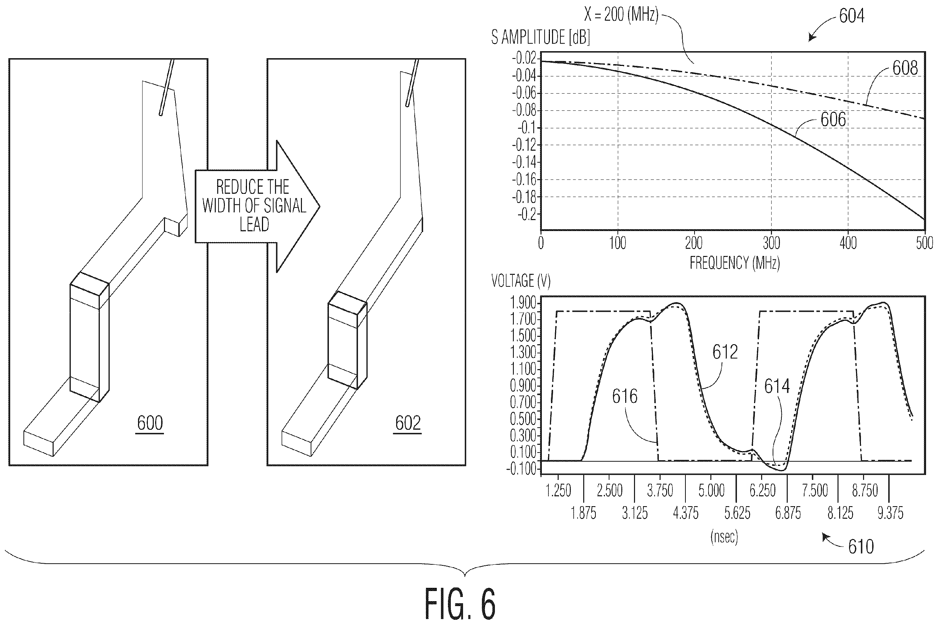

FIG. 6 illustrates a comparison of insertion loss and signal quality of a conventional signal lead and reduced width signal lead of a lead frame in accordance with an embodiment. A width of a conventionally sized signal lead 600 is reduced to signal lead 602 having a minimum width per manufacturer design rules in accordance with an embodiment.

Plot 604 illustrates an insertion loss of the conventional signal lead 600 and reduced width signal lead 602 as a function of frequency. The signal lead 602 has an insertion loss of 0.06 dB at 200 MHz shown by trace 606 while the conventional signal lead 600 has an insertion loss of 0.03 shown by trace 608, suggesting that there is no major degradation in insertion loss with the reduced width signal lead 602.

Plot 610 illustrates a signal quality of the conventional signal lead 600 and reduced width signal lead 602. An amplitude of a signal as a function of time is illustrated. Trace 616 shows a 200 MHz signal input to the conventional signal lead 600 and trace 612, 614 show the signal output by the conventional signal lead 600 and reduced width signal lead 602, respectively. The signals output are similar showing that signal quality for the two signal leads are similar even though widths as shown by signal leads 600, 602 may be different.

A semiconductor package comprises a leadframe with a first lead and a second lead where the first lead has a larger size compared to the second lead. The lead frame further comprises a die attach area on which a die with one or more bond pads of the die is attached and where the first lead and the second lead extend outwardly from the die attach area. The one or more bond pads are associated with the first lead and a plurality of bond wires is arranged between a bond pad and the first lead.

In an embodiment, a semiconductor package is disclosed. The package comprises: a lead frame having a first lead and a second lead and a die attach area, the first lead being a larger size than the second lead; a die arranged on the die attach area of the lead frame, the die comprising one or more bond pads of the die and wherein the first lead and the second lead extend outwardly from the die attach area; and a plurality of bond wires arranged between a bond pad and the first lead. In an example, the first lead has one or more of a larger width and thickness than the second lead, the first lead is a power lead and the second lead is a signal lead. In an example, the plurality of bond wires is arranged between a plurality of bond pads and the first lead and the first lead has a larger width than the second lead. In an example, the second lead has a width equal to a minimum width per minimum manufacturer design rule. In an example, the first lead has a slot between an inner portion of the first lead to an outer portion of the first lead, wherein the outer portion terminates with two pins. In an example, pins of the first lead are collectively wider in surface area than a pin of the second lead. In an example, the width of the first lead is between three to four times greater than a width of the second lead. In an example, a pin of the first lead is a same size as a pin of the second lead. In an example, the semiconductor package further comprises an encapsulant which encapsulates the die, the bond wires, the bond pad, and a portion of the leads.

In another embodiment, a lead frame is disclosed which comprises: a first lead and a second lead; and a die attach area, wherein the first lead and the second lead extend outwardly from the die attach area and wherein the first lead is a larger size than the second lead. In an example, the first lead has one or more of a larger width and thickness than the second lead. In an example, the width of the first lead is between three to four times greater than a width of the second lead. In an example, a slot is formed between an inner portion of the first lead to an outer portion of the first lead, wherein the outer portion terminates with two pins. In an example, the second lead has a width equal to a minimum width per manufacturer design rule.

In yet another embodiment, a method to manufacture a semiconductor package is disclosed. The method comprises: forming a lead frame which includes a die pad attach area, first lead, and second lead, wherein the first lead is a different size than the second lead and wherein the first lead and the second lead extend outwardly from the die attach area; attaching a die to the die attach area; coupling a plurality of bond wires from one or more bond pads of the die to the first lead; and encapsulating the die pad, one or more bond pads, bond wires, and a portion of the first lead and second lead with an encapsulant. In an example, the first lead has one or more of a larger width and thickness than the second lead. In an example, the plurality of bond wires is arranged between a plurality of bond pads and the first lead and the first lead has a larger width than the second lead. In an example, forming the first lead comprises forming a slot between an inner portion of the first lead to an outer portion of the first lead, wherein the outer portion terminates at two pins. In an example, the forming of the lead frame is performed by an etching or stamp punch process. In an example, the second lead has a width equal to a minimum width per manufacturer design rule.

For the sake of brevity, conventional semiconductor fabrication techniques may not be described in detail herein. In addition, certain terminology may also be used herein for reference only, and thus are not intended to be limiting, and the terms "first", "second" and other such numerical terms referring to structures do not imply a sequence or order unless clearly indicated by the context.

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with) another element, and not necessarily mechanically. Thus, although the schematic shown in the figures depict one exemplary arrangement of elements, additional intervening elements, devices, features, or components may be present in an embodiment of the depicted subject matter.

Although the operations of the method(s) herein are shown and described in a particular order, the order of the operations of each method may be altered so that certain operations may be performed in an inverse order or so that certain operations may be performed, at least in part, concurrently with other operations unless expressly indicated. In another embodiment, instructions or sub-operations of distinct operations may be implemented in an intermittent and/or alternating manner.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. A semiconductor package comprising:
a lead frame having a first lead and a second lead and a die attach area, the first lead being a larger size than the second lead;
a die arranged on the die attach area of the lead frame, the die comprising one or more bond pads and wherein the first lead and the second lead extend outwardly from the die attach area; and
a plurality of bond wires arranged between a bond pad of the die and the first lead.

2. The semiconductor package of any preceding claim, wherein the first lead has one or more of a larger width and thickness than the second lead, the first lead is a power lead and the second lead is a signal lead.

3. The semiconductor package of any preceding claim, wherein the plurality of bond wires is arranged between a plurality of bond pads and the first lead and the first lead has a larger width than the second lead.

4. The semiconductor package of any preceding claim, wherein the second lead has a width equal to a minimum width per minimum manufacturer design rule.

5. The semiconductor package of any preceding claim, wherein the first lead has a slot between an inner portion of the first lead to an outer portion of the first lead, wherein the outer portion terminates with two pins.

6. The semiconductor package of claim 5, wherein pins of the first lead are collectively wider in surface area than a pin of the second lead.

7. The semiconductor package of any preceding claim, wherein the width of the first lead is between three to four times greater than a width of the second lead.

8. The semiconductor package of any preceding claim, wherein a pin of the first lead is a same size as a pin of the second lead.

9. The semiconductor package of any preceding claim, further comprising an encapsulant which encapsulates the die, the bond wires, the bond pad, and a portion of the leads.

10. A method to manufacture a semiconductor package, the method comprising:
forming a lead frame which includes a die pad attach area, first lead, and second lead, wherein the first lead is a different size than the second lead and wherein the first lead and the second lead extend outwardly from the die attach area;
attaching a die to the die attach area;
coupling a plurality of bond wires from one or more bond pads of the die to the first lead; and
encapsulating the die pad, one or more bond pads, bond wires, and a portion of the first lead and second lead with an encapsulant.

11. The method of claim 10, wherein the first lead has one or more of a larger width and thickness than the second lead.

12. The method of claim 11, wherein the plurality of bond wires is arranged between a plurality of bond pads and the first lead and the first lead has a larger width than the second lead.

13. The method of any of claims 10 to 12, wherein forming the first lead comprises forming a slot between an inner portion of the first lead to an outer portion of the first lead, wherein the outer portion terminates at two pins.

14. The method of any of claims 10 to 13, wherein the forming of the lead frame is performed by an etching or stamp punch process.

15. The method of any of claims 10 to 14, wherein the second lead has a width equal to a minimum width per manufacturer design rule.
